# EUROPEAN PATENT APPLICATION

(11) **EP 4 556 802 A1**
(43) Date of publication of application: **21.05.2025**
(21) Application number: 23858565.7
(22) Date of filing: 28.02.2023
(51) Int. Cl.: F24F 1/24, F24F 1/22, F24F 11/88

(54) **CONTROLLER, AIR CONDITIONER OUTDOOR UNIT, AND AIR CONDITIONER**

(30) Priority: 31.08.2022 CN 202211057445
(71) Applicant: GD Midea Air-Conditioning Equipment Co., Ltd., Foshan, Guangdong 528311 (CN)
(72) Inventor: LIU, Shengli, Foshan, Guangdong 528311 (CN); LIAO, Jianzhen, Foshan, Guangdong 528311 (CN)
(74) Representative: RGTH
(86) International application number: PCT/CN2023/078756
(87) International publication number: WO 2024/045522

(57) **Abstract**

Disclosed are a controller, an air conditioner outdoor unit and an air conditioner. A controller (1000) includes a circuit board (100), and a module assembly (200) arranged at the circuit board (100). The module assembly (200) includes a first power module (210), a second power module (220), and a third power module (230). The circuit board (100) includes a first current circuit (211) connected to the first power module (210), a second current circuit (221) connected to the second power module (220), and a third current circuit (231) connected to the third power module (230). The first current circuit (211) and the second current circuit share (221) one or more circuit components.

## Description

### FIELD

The present disclosure relates to the technical field of air conditioning, and in particular to a controller, an air conditioner outdoor unit, and an air conditioner.

### BACKGROUND

A controller is a core component of an air conditioner. For an air conditioner outdoor unit with dual external fans, the controller requires a smaller circuit board to reduce costs and the fans and a compressor need independent power modules to drive. However, in the related art, the circuit board is large, leading to higher cost, and the power module of the fans may affect the power module current of the compressor, thus affecting the operation of the compressor.

### SUMMARY

The present disclosure aims to at least partially solve one of the problems existing in the related art. To this end, the present disclosure proposes a controller with a small circuit board and ensuring that power modules of fans do not affect the current of a power module for a compressor.

The present disclosure further provides an air conditioner outdoor unit having the controller, and an air conditioner having the controller.

According to an embodiment of a first aspect of the present disclosure, there is provided a controller, comprising a circuit board and a module assembly, where the module assembly is arranged at the circuit board. The module assembly comprises a first power module for driving a first fan, a second power module for driving a second fan, and a third power module for driving a compressor. The circuit board is provided with a first current circuit connected to the first power module, a second current circuit connected to the second power module, and a third current circuit connected to the third power module. The first current circuit and the second current circuit share a portion of a circuit structure.

The controller provided by the embodiments of the present disclosure has at least the following beneficial effects. Since the circuit board is provided with the first current circuit connected to the first power module and the second current circuit connected to the second power module, and the second current circuit and the first current circuit share some circuit structures, the total number of circuit structures arranged at the circuit board is reduced, thus reducing the size of the circuit board and reducing the production costs of the circuit board. In addition, as the third current circuit is provided separately from the first current circuit and is also provided separately from the second current circuit, that is, the third current circuit does not share any circuit structure with the first current circuit or the second current circuit, the first power module that drives the first fan and the second power module that drives the second fan do not affect the current of the third power module that drives the compressor.

According to an embodiment of the present disclosure, the circuit structures comprise a first capacitor, and the third current circuit comprises a second capacitor.

According to an embodiment of the present disclosure, a side surface of the circuit board facing the module assembly is a front surface, and the another side surface is a back surface. The circuit board is further provided with an output wiring connected to the second power module, the output wiring is located on the front surface of the circuit board. The wirings of the circuit structure is located on the back surface of the circuit board.

According to an embodiment of the present disclosure, the first current circuit comprises a first sampling resistor for sampling a current of the first fan, the second current circuit comprises a second sampling resistor for sampling a current of the second fan, and the third current circuit comprises a third sampling resistor for sampling a current of the compressor.

According to an embodiment of the present disclosure, the controller further comprises a heat sink, where the first power module, the second power module, and the third power module each abuts against the heat sink.

According to an embodiment of the present disclosure, the heat sink is in the shape of a rectangular plate. Length directions of the first power module, the second power module, and the third power module align with a length direction of the heat sink, and the first power module, the second power module, and the third power module are arranged in sequence along the length direction of the heat sink.

According to an embodiment of the present disclosure, a height of the first power module is equal to a height of the second power module, and is smaller than a height of the third power module. The heat sink is provided with a first step surface and a second step surface, the first step surface abuts against the first power module and the second power module, and the second step surface abuts against the third power module.

According to an embodiment of the present disclosure, the module assembly further comprises a rectifier module, an insulated gate bipolar transistor module and a fast recovery diode module arranged at the circuit board, and the rectifier module, the insulated gate bipolar transistor module and the fast recovery diode module are arranged in sequence along the length direction of the heat sink and each abuts against the heat sink.

According to an embodiment of the present disclosure, the controller further comprises a bracket fixed to the circuit board, where the bracket extends along the length direction of the heat sink and is arranged between the circuit board and the heat sink to support the module assembly.

According to an embodiment of the present disclosure, the bracket is provided with a first groove matching the first power module, a second groove matching the second power module and a third groove matching the third power module. Bottom walls of the first groove and the second groove are hollow-out structure. A bottom wall of the third groove is a first support plate for supporting the third power module, and the first support plate is provided with a first through hole for pins of the third power module to pass through.

According to an embodiment of the present disclosure, the circuit board is a rectangular plate with a length of a, wherein a satisfies the following condition: 233 mm ≤ a ≤ 253 mm.

According to an embodiment of a second aspect of the present disclosure, there is provided an air conditioner outdoor unit, comprising the controller according to the embodiments of the first aspect of the present disclosure.

The air conditioner outdoor unit according to the embodiments of the present disclosure has at least the following beneficial effects. Since the production costs of the circuit board are reduced, the overall costs of the air conditioner outdoor unit is reduced. In addition, since the third power module is not affected by the current of the other current circuits when driving the compressor, the operation of the compressor in the air conditioner outdoor unit is more stable.

According to an embodiment of the present disclosure, the air conditioner outdoor unit further comprises an electrical control box, where the controller is installed inside the electrical control box, and the module assembly is located on a side surface of the circuit board facing a bottom wall of the electrical control box.

According to an embodiment of a third aspect of the present disclosure, there is provided an air conditioner, comprising the air conditioner outdoor unit according to the embodiments of the second aspect of the present disclosure.

The air conditioner according to the embodiments of the present disclosure has at least the following beneficial effects. As the overall costs of the air conditioner outdoor unit decrease and the compressor in the air conditioner outdoor unit works more stably, the air conditioner has higher cost performance and is more likely to be favored by users.

Additional aspects and advantages of the present disclosure will be given in part in the following description, and will become apparent in part from the following description or be learned by practice of the present disclosure.

### BRIEF DESCRIPTION OF DRAWINGS

The present disclosure will be further explained hereinafter with reference to the accompanying drawings and embodiments. In the accompanying drawings:
FIG. 1 is a schematic layout diagram of a controller in which a module assembly, a rectifier module, an insulated gate bipolar transistor module and a fast recovery diode module are mounted on a circuit board according to an embodiment of the present disclosure;
FIG. 2 is a schematic diagram of a first current circuit of a controller according to an embodiment of the present disclosure;
FIG. 3 is a schematic diagram of a second current circuit of a controller according to an embodiment of the present disclosure;
FIG. 4 is a schematic diagram of a third current circuit of a controller according to an embodiment of the present disclosure;
FIG. 5 is a schematic exploded view of a controller according to an embodiment of the present disclosure;
FIG. 6 is a schematic exploded view of a controller from another view angle according to an embodiment of the present disclosure; and
FIG. 7 is an exploded side view of a controller according to an embodiment of the present disclosure.

List of reference signs:
controller 1000;
circuit board 100; second screw hole 110;
module assembly 200; first power module 210; first current circuit 211; first capacitor 2111; third capacitor 2112; first sampling resistor 2113; first bootstrap circuit 212; second power module 220; second current circuit 221; second sampling resistor 2211; second bootstrap circuit 222; output wiring 223; third power module 230; third current circuit 231; second capacitor 2311; fourth capacitor 2312; third sampling resistor 2313; third bootstrap circuit 232;
heat sink 300; first step surface 311; second step surface 312; first screw hole 320; mounting groove 330;
rectifier module 410; insulated gate bipolar transistor module 420; fast recovery diode module 430;
bracket 500; first groove 510; second groove 520; third groove 530; first support plate 532; first through hole 5321; fourth groove 540; second support plate 542; second through hole 5421; fifth groove 550; third support plate 552; third through hole 5521; sixth groove 560; fourth support plate 562; fourth through hole 5621; and third screw hole 570.

### DETAILED DESCRIPTION OF EMBODIMENTS

Embodiments of the present disclosure will be described in detail. Examples of the embodiments are illustrated in the accompanying drawings, where the same or like reference numerals throughout the figures indicates the same or like elements having the same or like functions. The embodiments described below with reference to the accompanying drawings are exemplary and are intended only to explain the present disclosure instead of being construed as limiting the present disclosure.

In the description of the present disclosure, it should be understood that, descriptions relating to orientation, for example, orientation or positional relationships indicated by "up," "down," "inside," "outside," etc. are based on the orientation or positional relationships shown in the accompanying drawings, and are to facilitate the description of the present disclosure and simplify the description only, rather than indicating or implying that the apparatus or element referred to must have a specific orientation or be constructed and operated in a specific orientation, and therefore should not be construed as limiting the present disclosure.

In the description of the present disclosure, the usage of terms such as "first" and "second," etc. is solely used for the purpose of distinguishing technical features and should not be construed as indicating or implying relative importance or implicitly indicating the number of indicated technical features or implicitly indicating the sequence of indicated technical features.

In the description of the present disclosure, unless otherwise explicitly defined, the terms such as "arrange," "install" and "connect" should be construed in a broad sense, and those skilled in the art can determine the specific meanings of the above terms in the present disclosure in a rational way in conjunction with the specific contents of the schemes.

It is well known that a controller is the core component of an air conditioner. For an air conditioner outdoor unit with dual external fans, the controller requires a smaller circuit board to reduce costs and the fans and a compressor need independent power modules to drive. However, in the related art, the circuit board is large, leading to higher cost, and the power module of the fans may affect the power module current of the compressor, thus affecting the operation of the compressor.

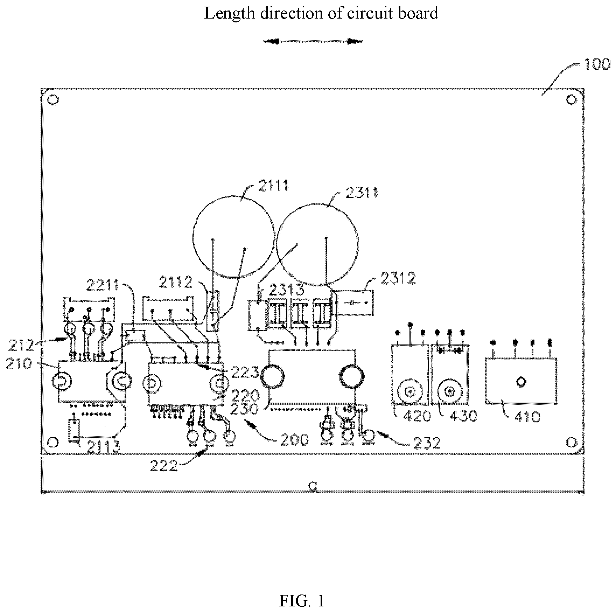

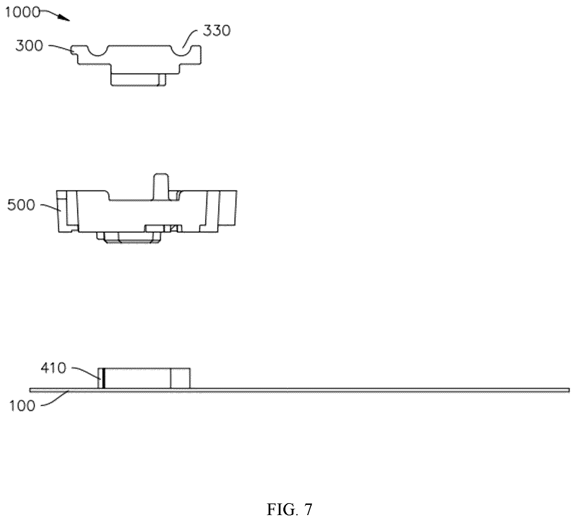

To this end, an embodiment of the first aspect of the present disclosure proposes a controller 1000, specifically as illustrated in FIGs. 1 to 7 in the accompanying drawings.

Referring to FIG. 1, a controller 1000 according to an embodiment of the present disclosure comprises a circuit board 100 and a module assembly 200. Referring to FIG. 1, the module assembly 200 is arranged at the circuit board 100, and the module assembly 200 comprises a first power module 210, a second power module 220, and a third power module 230. The first power module 210 is configured to drive a first fan, the second power module 220 is configured to drive a second fan, and the third power module 230 is configured to drive a compressor. It should be noted that both the first fan and the second fan are variable frequency fans, the compressor is a variable frequency compressor, and the first power module 210, the second power module 220, and the third power module 230 are all intelligent power modules (IPMs). It can be understood that the IPMs are small in size and highly reliable, and can meet the needs of driving the variable frequency fans and the variable frequency compressor. It can be understood that the first power module 210, the second power module 220, and the third power module 230 all have pins (not shown in the figures), and the pins are all soldered to the circuit board 100 by wave soldering. Wave soldering refers to the process of using molten soft solder (such as lead-tin alloy) to create a solder wave of specified design through an electric pump or electromagnetic pump. Nitrogen gas may also be injected into the solder bath to form the solder wave. The printed circuit board (PCB, i.e. the circuit board 100 in the embodiments of the present disclosure) comprises pre-stalled components (such as the first power module 210, second power module 220, and third power module 230 in the embodiments of the present disclosure), which can mechanically and electrically connects to the PCB pad with their welding terminals or pins by the solder wave to form a soft solder joint.

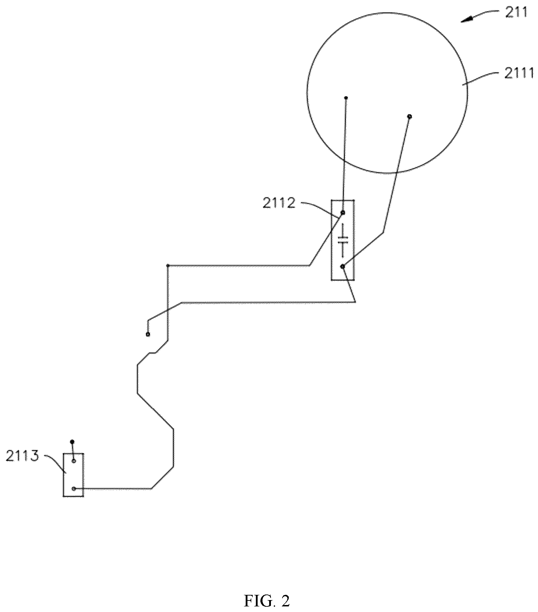

Referring to FIGs. 1 and 2, in the controller 1000 according to an embodiment of the present disclosure, the circuit board 100 is provided with a first current circuit 211, and the first current circuit 211 is connected to the first power module 210 and supplies power to the first power module 210, such that the first power module 210 drives a first fan. In an embodiment, circuit structures of the first current circuit 211 comprise a first capacitor 2111, a third capacitor 2112, and a first sampling resistor 2113. The first capacitor 2111 is an electrolytic capacitor that functions to filter and stabilize the voltage. The third capacitor 2112 is a bypass capacitor, which is used for filtering out high-frequency interference signals. The first sampling resistor 2113 is a current sampling resistor, which is used for sampling the current of the first fan in the first current circuit 211. Referring to FIG. 1, the circuit board 100 is provided with a first bootstrap circuit 212, and the first bootstrap circuit 212 is connected to the first power module 210 to improve the operating stability of the first power module 210.

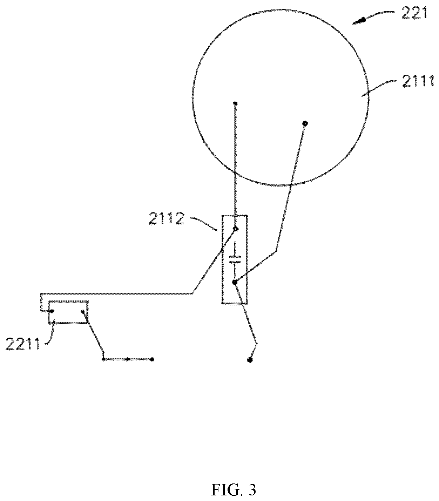

Referring to FIGs. 1 and 3, in the controller 1000 according to an embodiment of the present disclosure, the circuit board 100 is further provided with a second current circuit 221, and the second current circuit 221 is connected to the second power module 220 and supplies power to the second power module 220, such that the second power module 220 drives a second fan. In an embodiment, circuit structures of the second current circuit 221 comprise a first capacitor 2111, a third capacitor 2112, and a second sampling resistor 2211. The first capacitor 2111 is an electrolytic capacitor that functions to filter and stabilize the voltage. The third capacitor 2112 is a bypass capacitor, which is used for filtering out high-frequency interference signals. The second sampling resistor 2211 is a current sampling resistor, which is used for sampling the current of the second fan in the second current circuit 221. Referring to FIG. 1, the circuit board 100 is provided with a second bootstrap circuit 222, and the second bootstrap circuit 222 is connected to the second power module 220 to improve the operating stability of the second power module 220.

It should be noted that the first current circuit 211 and the second current circuit 221 share some circuit structures. Referring to FIGs. 1, 2 and 3, in some embodiments, the circuit structures shared by the first current circuit 211 and the second current circuit 221 are the first capacitor 2111 and the third capacitor 2112. It can be understood that since both the first current circuit 211 and the second current circuit 221 are provided on the circuit board 100, and the second current circuit 221 and the first current circuit 211 share some circuit structures, the total number of circuit structures provided on the circuit board 100 is reduced, thereby reducing the size of the circuit board 100 and reducing the production costs of the circuit board 100. It should be noted that a surface of the circuit board 100 facing the module assembly 200 is a front surface, the other surface is a back surface. The circuit board 100 is further provided with an output wiring 223 connected to the second power module 220, the output wiring 223 is located on the front surface of the circuit board 100. Wirings of the circuit structures are located on the back surface of the circuit board 100. It can be understood that, with the above arrangement, the layout area of the circuit board 100 is smaller, saving on materials of the circuit board 100.

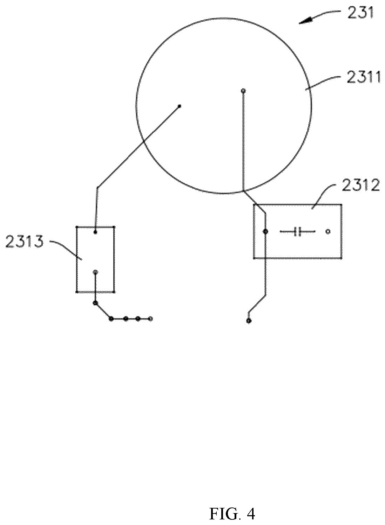

Referring to FIGs. 1 and 4, in the controller 1000 according to an embodiment of the present disclosure, the circuit board 100 is further provided with a third current circuit 231, and the third current circuit 231 is connected to the third power module 230 and supplies power to the third power module 230, such that the third power module 230 drives a compressor. In an embodiment, circuit structures of the third current circuit 231 comprise a second capacitor 2311, a fourth capacitor 2312, and a third sampling resistor 2313. The second capacitor 2311 is an electrolytic capacitor that functions to filter and stabilize the voltage. The fourth capacitor 2312 is a bypass capacitor, which is used for filtering out high-frequency interference signals. The third sampling resistor 2313 is a current sampling resistor, which is used for sampling the current of the compressor in the third current circuit 231. Referring to FIG. 1, the first capacitor 2111 is adjacent to the second capacitor 2311, which facilitates installation of the first capacitor 2111 and the second capacitor 2311. It can be understood that as the third current circuit 231 is provided separately from the first current circuit 211 and is also provided separately from the second current circuit 221, that is, the third current circuit 231 does not share any circuit structure with the first current circuit 211 or the second current circuit 221, the first power module 210 that drives the first fan and the second power module 220 that drives the second fan do not affect the current of the third power module 230 that drives the compressor. Referring to FIG. 1, the circuit board 100 is provided with a third bootstrap circuit 232, and the third bootstrap circuit 232 is connected to the third power module 230 to improve the operating stability of the third power module 230.

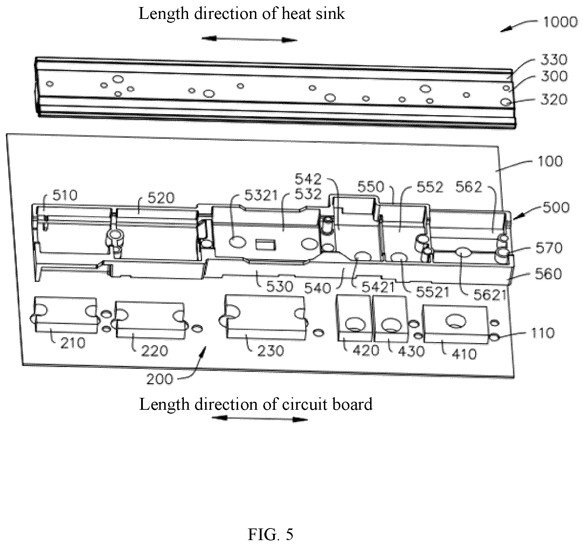

Referring to FIG. 5, in the controller 1000 according to an embodiment of the present disclosure, the controller 1000 further comprises a heat sink 300, and the first power module 210, the second power module 220, and the third power module 230 each abuts against the heat sink 300 to dissipate heat. It should be noted that the first power module 210, the second power module 220, and the third power module 230 are each provided in a rectangular parallelepiped shape, and each of the three power modules described above has two opposing surfaces with the largest area, with one surface facing the circuit board and the other surface abuts against the heat sink 300. It can be understood that with the above arrangement, the heat generated by the first power module 210, the second power module 220, and the third power module 230 during operation can be transferred to the heat sink 300, and then heat is dissipated through the heat sink 300. In an embodiment, the heat sink 300 is provided with a mounting groove 330 extending in the length direction thereof, and a refrigerant pipe is mounted in the mounting groove 330 to take away the heat absorbed by the heat sink 300. In another embodiment, the heat sink 300 is provided with a mounting hole (not shown in the figure) extending in the length direction thereof, and a refrigerant pipe is mounted in the mounting hole to take away the heat absorbed by the heat sink 300.

Referring to FIG. 1, in the controller 1000 according to an embodiment of the present disclosure, the circuit board 100 is in the shape of a rectangular plate, and the circuit board 100 has a length of a, where the length a satisfies the following condition: 233 mm ≤ a ≤ 253 mm. Within this range, the circuit board 100 can accommodate the requirement for multiple power modules to be arranged along the length direction. In an embodiment, the length of the circuit board 100 is 243 mm. Referring to FIG. 5, the heat sink 300 is also in the shape of a rectangular plate, the length directions of the first power module 210, the second power module 220, and the third power module 230 align with the length direction of the heat sink 300, and the first power module 210, the second power module 220, and the third power module 230 are arranged in sequence along the length direction of the heat sink 300. It can be understood that by the above arrangement, all space of the heat sink 300 can be utilized, and the volume of the heat sink 300 is reduced, thereby reducing the manufacturing and processing costs of the heat sink 300. In an embodiment, the length direction of the heat sink 300 is the same as the length direction of the circuit board 100. It should be noted that the length direction of the circuit board 100 aligns with the direction during wave soldering of the controller 1000, and since the first power module 210, the second power module 220, and the third power module 230 are arranged in sequence along the length direction of the heat sink 300 (that is, along the length direction of the circuit board 100), the probability of passing through a wave peak at one time is relatively high, the solder bridging of the pins of the above three modules is alleviated, and the production efficiency is improved.

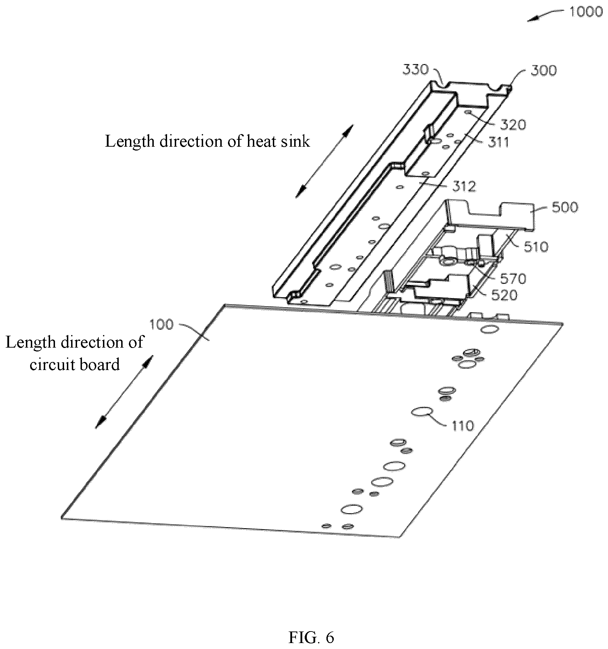

Referring to FIG. 6, in the controller 1000 according to an embodiment of the present disclosure, a height of the first power module 210 is equal to a height of the second power module 220, and is smaller than a height of the third power module 230. The heat sink 300 is provided with a first step surface 311 and a second step surface 312. It can be understood that both the first step surface 311 and the second step surface 312 are provided on a side of the heat sink 300 facing the circuit board 100. The first step surface 311 abuts against the first power module 210 and the second power module 220, and the second step surface 312 abuts against the third power module 230, that is, a height difference between the first step surface 311 and the second step surface 312 is approximately equal to a height difference between the third power module 230 and the first power module 210, or a height difference between the first step surface 311 and the second step surface 312 is approximately equal to a height difference between the third power module 230 and the second power module 220. It can be understood that by providing the first step surface 311 and the second step surface 312, the first power module 210, the second power module 220, and the third power module 230 can all be brought into contact with the heat sink 300 and transfer heat generated during operation to the heat sink 300 for heat dissipation. It should be noted that depending on the specific heights of the first power module 210, the second power module 220, and the third power module 230, the heat sink 300 may be provided with a flat surface without providing steps, or a plurality of steps may be provided, which is not particularly limited here.

Referring to FIGs. 1 and 5, in the controller 1000 according to an embodiment of the present disclosure, the module assembly 200 further comprises a rectifier module 410, an insulated gate bipolar transistor module 420, and a fast recovery diode module 430 provided on the circuit board 100. Herein, the rectifier module 410 comprises a rectifier bridge, the insulated gate bipolar transistor module 420 comprises an insulated gate bipolar transistor (IGBT), and the fast recovery diode module 430 comprises a fast recovery diode (FRD). It should be noted that the module assembly 200 rectifies an input alternating current into direct current by the rectifier module 410, the insulated gate bipolar transistor module 420, and the fast recovery diode module 430. The rectifier module 410, the insulated gate bipolar transistor module 420, and the fast recovery diode module 430 are arranged in sequence along the length direction of the heat sink 300, and each abuts against the heat sink 300. It can be understood that when the rectifier module 410, the insulated gate bipolar transistor module 420, and the fast recovery diode module 430 perform rectification operation, heat is generated, and the generated heat is transferred to the heat sink 300 and taken away by the refrigerant pipe, thereby realizing heat dissipation.

Referring to FIGs. 1 and 5, in an embodiment, the first power module 210, the second power module 220, the third power module 230, the rectifier module 410, the insulated gate bipolar transistor module 420, and the fast recovery diode module 430 are arranged in sequence along the length direction of the heat sink 300. It can be understood that with the above arrangement, only one rectangular heat sink 300 is used to realize heat dissipation of six modules (the first power module 210, the second power module 220, the third power module 230, the rectifier module 410, the insulated gate bipolar transistor module 420, and the fast recovery diode module 430), which greatly reduces the number of components of the controller 1000 and also reduces the costs of the controller 1000.

Referring to FIGs. 5, 6, and 7, in the controller 1000 according to an embodiment of the present disclosure, the controller 1000 further comprises a bracket 500 fixed to the circuit board 100, and the bracket 500 extends along the length direction of the heat sink 300 and is provided between the circuit board 100 and the heat sink 300 to support the module assembly 200. It should be noted that the bracket 500 may be fixedly connected to the circuit board 100 using methods such as threaded connections. In an embodiment, the heat sink 300 is provided with first screw holes 320, the circuit board 100 is provided with second screw holes 110, the bracket 500 is provided with third screw holes 570, and screws are arranged to pass through the first screw holes 320, the second screw holes 110, and the third screw holes 570 to fix the bracket 500 and the heat sink 300 to the circuit board 100, and the bracket 500 supports the module assembly 200, such that the first power module 210, the second power module 220, and the third power module 230 abut against the heat sink 300.

Referring to FIG. 5, in the controller 1000 according to an embodiment of the present disclosure, the bracket 500 is provided with a first groove 510, a second groove 520, and a third groove 530. The first groove 510 matches the first power module 210, and it can be understood that the first power module 210 is mounted in the first groove 510 and connected to the circuit board 100. The second groove 520 matches the second power module 220, and it can be understood that the second power module 220 is mounted in the second groove 520 and connected to the circuit board 100. The third groove 530 matches the third power module 230, and it can be understood that the third power module 230 is mounted in the third groove 530 and connected to the circuit board 100.

Referring to FIG. 5, in the controller 1000 according to an embodiment of the present disclosure, the bottom walls of the first groove 510 and the second groove 520 are hollow-out structure. It should be noted that the pins of the first power module 210 that drives the first fan and the second power module 220 that drives the second fan are relatively short, and the bottom walls of the first groove 510 and the second groove 520 are hollowed out structure, which can facilitate the installation of the first power module 210 and the second power module 220. It is understood that after the first power module 210 is mounted in the first groove 510, the first groove 510 supports the peripheral sides of the first power module 210. After the second power module 220 is mounted in the second groove 520, the second groove 520 supports the peripheral sides of the second power module 220. The bottom wall of the third groove 530 is a first support plate 532 that supports the third power module 230, and the first support plate 532 is provided with a first through hole 5321 for pins of the third power module 230 to pass through. It should be noted that the pins of the third power module 230 that drives the compressor are relatively long, and the first support plate 532 can support the third power module 230, so that the installation of the third power module 230 is more stable. It should be noted that after the pins of the third power module 230 pass through the first through hole 5321 and the third power module 230 is mounted in the third groove 530, the third groove 530 also supports the peripheral sides of the third power module 230.

Referring to FIG. 5, in the controller 1000 according to an embodiment of the present disclosure, the bracket 500 is further provided with a fourth groove 540, a fifth groove 550, and a sixth groove 560. The fourth groove 540 matches the insulated gate bipolar transistor module 420, and it can be understood that the insulated gate bipolar transistor module 420 is mounted in the fourth groove 540 and connected to the circuit board 100. It should be noted that the bottom wall of the fourth groove 540 is a second support plate 542 that supports the insulated gate bipolar transistor module 420, and the second support plate 542 is provided with a second through hole 5421 for the pins of the insulated gate bipolar transistor module 420 to pass through. The pins of the insulated gate bipolar transistor module 420 are relatively long, and the second support plate 542 can support the insulated gate bipolar transistor module 420, so that the mounting of the insulated gate bipolar transistor module 420 is more stable. It should be noted that after the pins of the insulated gate bipolar transistor module 420 pass through the second through hole 5421 and the insulated gate bipolar transistor module 420 is mounted in the fourth groove 540, the fourth groove 540 also supports the peripheral sides of the insulated gate bipolar transistor module 420.

Referring to FIG. 5, in the controller 1000 according to an embodiment of the present disclosure, the fifth groove 550 matches the fast recovery diode module 430. It can be understood that the fast recovery diode module 430 is mounted in the fifth groove 550 and connected to the circuit board 100. It should be noted that the bottom wall of the fifth groove 550 is a third support plate 552 that supports the fast recovery diode module 430, and the third support plate 552 is provided with a third through hole 5521 for pins of the fast recovery diode module 430 to pass through. The specific functions of the fifth groove 550, the third support plate 552, and the third through hole 5521 are similar to those of the fourth groove 540, the second support plate 542, and the second through hole 5421 described above, and will not be repeatedly described here. Referring to FIG. 5, in the controller 1000 according to an embodiment of the present disclosure, the sixth groove 560 matches the rectifier module 410. It can be understood that the rectifier module 410 is mounted in the sixth groove 560 and connected to the circuit board 100. It should be noted that the bottom wall of the sixth groove 560 is a fourth support plate 562 that supports the rectifier module 410, and the fourth support plate 562 is provided with a fourth through hole 5621 for pins of the rectifier module 410 to pass through. The specific functions of the sixth groove 560, the fourth support plate 562, and the fourth through hole 5621 are similar to those of the fourth groove 540, the second support plate 542, and the second through hole 5421 described above, and will not be repeatedly described here.

An embodiment of the second aspect of the present disclosure further provides an air conditioner outdoor unit, not shown in the figures, which comprises the controller 1000 of the embodiments of the first aspect.

For the air conditioner outdoor unit according to the embodiments of the present disclosure, since the production costs of the circuit board 100 are reduced, the overall costs of the air conditioner outdoor unit is reduced; and in addition, since the third power module 230 is not affected by the current of the other current circuits when driving the compressor, the operation of the compressor in the air conditioner outdoor unit is more stable.

According to an embodiment of the present disclosure, the air conditioner outdoor unit further comprises an electrical control box. The controller 1000 is installed inside the electrical control box, and the module assembly 200 is located on a side of the circuit board 100 facing a bottom wall of the electrical control box. With the above-described arrangement, the accumulation of dust on the module assembly 200 can be prevented, ensuring the proper functioning of the controller 1000.

An embodiment of the third aspect of the present disclosure further provides an air conditioner, not shown in the figures, comprising the air conditioner outdoor unit of the embodiments of the second aspect.

For the air conditioner according to the embodiments of the present disclosure, as the overall costs of the air conditioner outdoor unit decrease and the compressor in the air conditioner outdoor unit works more stably, the air conditioner has higher cost performance and is more likely to be favored by users.

The embodiments of the present disclosure have been described in detail above with reference to the accompanying drawings, and finally, it should be noted that the above embodiments are only used to illustrate the technical scheme of the present disclosure and are not intended to limit the present disclosure. Although the present disclosure has been described in detail with reference to the foregoing embodiments, those of ordinary skill in the art will understand that modifications can be made to the technical schemes described in the aforementioned embodiments, or equivalent replacements can be made to some of or all the features in the embodiments; and these modifications or replacements do not make the essence of the corresponding technical schemes deviate from the contents of the technical schemes of the embodiments of the present disclosure.

## Claims

1. A controller comprising:
a circuit board; and
a module assembly arranged at the circuit board, the module assembly comprising a first power module for driving a first fan, a second power module for driving a second fan, and a third power module for driving a compressor; and
wherein the circuit board is provided with a first current circuit connected to the first power module, a second current circuit connected to the second power module, and a third current circuit connected to the third power module, and the first current circuit and the second current circuit share a portion of a circuit structure.

2. The controller of claim 1, wherein the circuit structure comprises a first capacitor, and the third current circuit comprises a second capacitor.

3. The controller of claim 1, wherein a side surface of the circuit board (100) facing the module assembly (200) is a front surface, and another side surface is a back surface, and the circuit board further comprises an output wiring connected to the second power module, the output wiring is located on the front surface of the circuit board, and a wiring of the circuit structure is located on the back surface of the circuit board.

4. The controller of claim 1, wherein the first current circuit comprises a first sampling resistor for sampling a current of the first fan, the second current circuit comprises a second sampling resistor for sampling a current of the second fan, and the third current circuit comprises a third sampling resistor for sampling a current of the compressor.

5. The controller of claim 1, further comprising a heat sink, wherein the first power module, the second power module, and the third power module each abuts against the heat sink.

6. The controller of claim 5, wherein the heat sink is in a shape of a rectangular plate, length directions of the first power module, the second power module, and the third power module align with a length direction of the heat sink, and the first power module, the second power module, and the third power module are arranged in sequence along the length direction of the heat sink.

7. The controller of claim 6, wherein a height of the first power module is equal to a height of the second power module and is smaller than a height of the third power module, the heat sink is provided with a first step surface and a second step surface, the first step surface abuts against the first power module and the second power module, and the second step surface abuts against the third power module.

8. The controller of claim 6, wherein the module assembly further comprises a rectifier module, an insulated gate bipolar transistor module and a fast recovery diode module arranged at the circuit board, and the rectifier module, the insulated gate bipolar transistor module and the fast recovery diode module are arranged in sequence along the length direction of the heat sink and each abuts against the heat sink.

9. The controller of any one of claim 6, 7 or 8, further comprising a bracket fixed to the circuit board, wherein the bracket extends along the length direction of the heat sink and is arranged between the circuit board and the heat sink to support the module assembly.

10. The controller of claim 9, wherein the bracket is provided with a first groove matching the first power module, a second groove matching the second power module and a third groove matching the third power module, bottom walls of the first groove and the second groove are hollow-out structure, a bottom wall of the third groove is a first support plate for supporting the third power module, and the first support plate is provided with a first through hole for pin of the third power module to pass through.

11. The controller of claim 6, wherein the circuit board is a rectangular plate with a length of a, wherein a satisfies the following condition: 233 mm ≤ a ≤ 253 mm.

12. An air conditioner outdoor unit, comprising a controller of any one of claims 1 to 11.

13. The air conditioner outdoor unit of claim 12, further comprising an electrical control box, wherein the controller is installed inside the electrical control box, and a module assembly is located on a side surface of a circuit board facing a bottom wall of the electrical control box.

14. An air conditioner, comprising an air conditioner outdoor unit of claim 12 or 13.
